Europäisches Patentamt

European Patent Office

Office européen des brevets

(11) Publication number: **0 259 784**
**A2**

# (12) EUROPEAN PATENT APPLICATION

(21) Application number: **87112870.8**

(22) Date of filing: **03.09.87**

(51) Int. Cl.⁴: **H05K 3/46**

(30) Priority: **11.09.86 US 906107**

(43) Date of publication of application:
**16.03.88 Bulletin 88/11**

(84) Designated Contracting States:
**DE GB NL**

(71) Applicant: **GENERAL ELECTRIC COMPANY**
**1 River Road**
**Schenectady New York 10022(US)**

(72) Inventor: **Wacker, Thomas Patrick**
**208 Fillmore Avenue**
**Schenectady New York 12304(US)**
Inventor: **Eichelberger, Charles William**
**1256 Waverly Place**
**Schenectady New York 12308(US)**
Inventor: **Wojnarowski, Robert John**
**102 Hatlee Road, RD 6**
**Ballston Lake New York 12019(US)**

(74) Representative: **Sieb, Rolf, Dr. et al**
**General Electric-Deutschland**
**Patentabteilung Kaiserstrasse 41**
**D-6000 Frankfurt am Main 1(DE)**

(54) **Photo-imaged dielectric layer.**

(57) Photo-imaging is used to produce dielectric layers in multi-layer conductor assemblies.

EP 0 259 784 A2

## PHOTO-IMAGED DIELECTRIC LAYER

The present invention relates to a method for applying dielectric layers to a conductive pattern on a substrate. More particularly, the present invention relates to a method for applying dielectric layers to such conductive patterns utilizing photo-imaging.

Background of the Invention

The application of dielectric layers to conductive patterns has become of greater interest with the recent development of multi-layer circuit boards produced by augmentative replacement methods. The conductive patterns or tracings of these multi-layer circuit boards are produced by augmentative replacement which is an additive method and as such greatly facilitates the application of multiple layers of patterns to a single substrate. The multiple patterns are separated by and adhered to dielectric layers, the purpose of which is to separate the conductive patterns and prevent shorts where conductors of the patterns overlap.

U.S. Pat. Nos. 4,404,237, Eichelberger, et al., and 4,470,883, Eichelberger, et al., describe the production of conductive patterns by augmentative replacement methods. U.S. Pat. No. 4,416,914, Eichelberger, et al., describe the production of multi-layer circuit boards where such conductive patterns are utilized. Each of the above patents are hereby incorporated by reference.

It is seen in Eichelberger, et al., '914, that the preferred method for applying the dielectric layer is screen printing. However, as further stated therein, such method produces a dielectric layer with several drawbacks. Dielectric layers applied by screen printing have an imperfect surface generally due to screen holes and pin marks. A heating step is generally required to improve the surface by allowing the polymer of the dielectric layer to flow and self level. Such heating step in itself produces further problems. The dielectric may flow into through holes during such heating and plug them. Further, the dielectric polymer may flow into gaps which were purportedly left open in order to make an interconnection. Preventing this type of undesirable flow requires that the placement of the dielectric material, as well as the time and temperature of heating, be precisely controlled so that only a controlled amount of flow is permitted.

It is an object of the present invention to provide a method whereby the dielectric layer can be applied to the conductive pattern without the surface imperfections due to screen application.

It is a further object of the present invention to provide a method whereby the dielectric layer can be applied with greater accuracy to the conductive pattern.

Finally, it is an object of the present invention to eliminate the necessity of heating the dielectric layer subsequent to application.

Detailed Description of the Invention

Briefly, according to the present invention, there is provided a method to apply a dielectric layer to a conductive pattern, said method comprising the steps of:

(a) coating the conductive pattern with photo-curable dielectric polymeric material,

(b) exposing said photo-curable dielectric polymeric material to photo-curing light in the pattern of desired cure, and

(c) developing the photocurable dielectric polymeric material.

The conductive pattern for use herein may be established by conventional printed circuit techniques, on a chosen substrate, such as a glass epoxy blank and the like, laminated with conductive foil. The conductive pattern is imaged in the foil by conventional resist imaging techniques. Alternatively, the desired conductive pattern may be provided by means of a metal containing cured polymer which is subjected to an augmentative replacement reaction as described in U.S. Pat. No. 4,404,237 and 4,470,883, issued to Eichelberger, et al.

The augmentative reaction process is particularly adapted for the use of screen printing techniques to establish conductor patterns on the substrates, although the invention may also be practiced utilizing other techniques including photoimaging techniques and the like. Further such techniques include, without limitation, pad flexographic printing, stencil, rotogravure, and offset printing.

The substrate on which the conductive patterns are formed is not restricted and any insulator to which the metal ink can be adhered is employable. Thus, the usual printed circuit substrates can be used as well as glass filled polyesters, phenolic boards, polystyrene, glass and steel covered with a porcelin or epoxy insulator, and the like. Of particular interest as substrates for use in the present invention are of course, previously laid down dielectric layers, as would be present in multi-layer circuit board construction. On such substrates, augmentative replacement would be the preferred method of establishing the conductive pattern.

Metal containing polymers, or metal inks, used in augmentative replacement are a combination of a finely divided metallic powder composition with a polymer whose viscosity and flow characteristics are controlled by the incorporation of a solvent therein. The metal can be any metal which is stable in the ink and cured polymer and which can be obtained in finely divided form and which is placed above the metal used in the augmentative replacement reaction in the activity series of the metals. Because of its availability and low cost, the preferred metal is iron. The metal powder generally has a particle size of less than about 50 microns, preferably 3 to about 25 microns and most preferably about 15-25 microns. When the ink is deposited by screen printing, the metal particles must be of a size to pass through the screen.

The polymers employed in the ink are any curable material or mixture thereof which exhibits a degree of adhesion to the substrate being employed and to the finely divided metal powder which is dispersed therein. Typical polymers which can be employed include the homopolymers and copolymers of ethylenically unsaturated aliphatic, alicyclic and aromatic hydrocarbons such as polyethylene, polypropylene, polybutene, ethylene propylene copolymers, copolymers of ethylene or propylene with other olefins, polybutadiene, polyisoprene, polystyrene and polymers of pentene, hexene, heptene bicyclo-(2,2,1) 2-heptane, methyl styrene and the like. Other polymers which can be used include polyindene, polymers of acrylate esters and polymers of acrylate esters and polymers of methacrylate esters, acrylate and methacrylate resins such as ethyl acrylate, n-butyl methacrylate, isobutyl methacrylate, ethyl methacrylate and methyl methacrylate; alkyd resins; cellulose derivatives such as cellulose acetate, cellulose acetate butyrate, cellulose nitrate, ethyl cellulose, hydroxyethyl cellulose, methyl cellulose, and sodium carboxymethyl cellulose; epoxy resins; hydrocarbon resins from petroleum; isobutylene resins; isocyanate resins (polyurethanes); melamine resins such as melamine-formaldehyde and melamine-urea-formaldehyde; oleo-resins, polyamide polymers such as polyamides and polyamide-epoxy polyesters; polyester resins such as the unsaturated polyesters of dibasic acids and dihydroxy compounds; polyester elastomer and resorcinol resins such as resorcinol-formaldehyde, resorcinol-furfural, resorcinol-phenol-formaldehyde, and resorcinol-urea; rubbers such as natural rubber, reclaimed rubber, chlorinated rubber, butadiene styrene rubber, and butyl rubber, neoprene rubber, polysulfide, vinyl acetate and vinyl alcohol-acetate copolymers, polyvinyl alcohol, polyvinyl chloride, polyvinyl pyrollidone and polyvinylidene chloride, polycarbonates, graft copolymers of polymers of unsaturated hydrocarbons and of unsaturated monomers such as graft copolymers of polybutadiene, styrene and acrylonitrile, commonly called ABS resins, polyamides and the like, including those additional examples detailed in the aforementioned Eichelberger, et al., patents.

The polymers and inks of the present invention can contain various other materials such as fillers, e.g., glass fiber, glass powder, glass beads, asbestos, mineral fillers, wood flower and other vegetable fillers, dyes, pigments, waxes, stabilizers, lubricants, curing catalysts such peroxides, photosensitizers and amines, polymerization inhibitors adhesion promoters, wetting agents and the like. It is preferred, but not essential, to employ a polymer which exhibits a substantial degree of volumetric shrinkage upon curing.

The amounts of the finely divided metal and polymer are adjusted such that the metal constitutes about 60-80% by volume of the mixture after curing. Preferably, the metal is about 70% by volume. It is desired to have the surface of the cured ink contain a significant amount of the metal particles to facilitate the subsequent augmentative replacement reaction.

A solvent is used in the ink formulation in order to adjust the viscosity and flow characteristics for the type of printing desired. In general, the solvent should be employed in an amount sufficient that the ink has a viscosity of 15,000-200,000 cps at room temperature and preferably about 50,000-150,000 cps. Suitable solvents or diluents can be aliphatic or aromatic and usually contain up to about 30 carbon atoms. They include the hydrocarbons, ethers and thioethers, carbonyl compounds such as esters and ketones, nitrogen containing compounds such as amides, amines, nitriles and nitro compounds, alcohols, phenols, mercaptans and halogen containing compounds. Examples include alcohols such as methanol, ethanol, propanol, benzyl alcohol, cyclohexanol, ethylene glycol, glycerol and the like, aromatic materials such as benzene, toluene, xylene, ethyl benzene, naphthalene, tetralin and the like, ethers such as methyl ether, ethyl ether, propyl ether, methyl t-butyl ether, and the like, alkanes such as methane, ethane, propane and the like, dimethyl sulfoxide, butyl formate, methyl acetate, ethyl acetate, formamide, dimethyl formamide, acetamide, acetone, nitrobenzene, monochlorobenzene, acetophoenone, tetrahydrofuran, chloroform, carbon tetrachloride, trichloroethylene, ethylbromide, phenol, mercaptophenol, and the like. Additionally, reactive solvents or diluents such as triallyl isocyanurate can be used if desired. It is preferred to employ a solvent which is relatively non-volatile at room temperature so that the viscosity and flow of the ink is appropriate during application to the substrate and highly volatile at the curing temperature of the polymer or at other temperatures above the application temperature. The carbitol series of solvents and particularly butyl carbitol (diethylene glycol monobutyl ether) has been found to be particularly appropriate.

The ink is applied to the substrate to achieve the desired conductor patterns thereon. For example, standard printed circuit application technology can be employed. Any temperature which will not cause premature curing of the ink and at which the viscosity and flow characteristics of the ink are appropriate to the application technique used can be employed. It is preferred, but not necessary, to permit at least a portion of the solvent to evaporate after application of the ink to the substrate and before curing. The act of evaporation exposes addition metal powder and increases the ratio of metal powder to polymer so as to achieve a balance between sufficient metal to provide a base for the conductive film to be formed thereon and too little polymer to act as a binder to hold the metal particles. Preferably, the drying is effected for 0.1 - 1 hour, more preferably, about 0.25 - 0.5 hour, at a temperature of about 70° - 150°C., most preferably about 110° - 130°C.

The ink polymer is cured or polymerized by the most convenient method. If an autocatalyst has been added, the polymer will cure by itself with no additional initiation. In the case of ultraviolet light initiators, the substrates carrying the conductor patterns can be passed under a high intensity ultraviolet source which causes the initiators to begin the curing reaction. It is presently preferred to employ a thermal curing system which is activated by exposure to temperatures of about 140° - 200°C., preferably about 150° - 180°C., for a time of 0.1 - 1 hour, preferably, 0.15 - 0.5 hour. As a result of this step, a closely compacted metal powder bound to the substrate by the cured polymer is achieved. Because of the high percentage of metal and shrinkage of the polymer chosen, the conductive pattern thus obtained may have some conductivity due to physical contact between the metal particles. In the preferred embodiment of this invention that conductivity is on the order of about 30 Kohm per square for a one mil thick deposit. The resistance will be highly variable and increase substantially if the system is subjected to oxidizing conditions for any period of time since an oxide builds up between particles and reduces conductivity.

In some instances, it may be desirable to only partially cure the polymer. For example, occasions arise where it is desirable to mount components by inserting the leads thereof in the polymer ink. In such instances, it may be desirable to partially cure the polymer or only gel the polymer in situations where the polymer employed is gelable, so as to provide an adhesive for the lead wire.

The ink-designed substrate is subjected to an augmentation replacement reaction in which some of the metal of the powder is replaced by a metal further down in the activity series, i.e., which is more noble. This step takes advantage of the known chemical behavior of metals, i.e. that any metal will displace any succeeding, less active, metal from a water solution of one of its salts. However, in this invention, it has been found that while the powder metal enters into solution from the surface and somewhat below the surface o thepolymer, the plating out of the more-noble metal takes place to a large extent on the surface. Thus, an additional amount of more-noble metal is deposited on the surface than that which would form a one-to-one exchange with the powder metal at the surface. The additional metal from the solution plates to the original and replacement metal particles which are adhered to the substrate by the polymer to interconnect all metal particles at the surface and thus form a contiguous film of conductive metal over the printed conductor pattern. It has been found that several hundred microinches of conductor material can be built up from a solution in a period of 5 minutes.

The augmentative reaction reagent is a solution, preferably inorganic and most preferably aqueous, of a metal salt. The cation of the metal salt is any more noble or electropositive metal than the metal of the finely divided powder, i.e., lies below the powder metal in the activity series, and which is electrically conductive. Any anion can be used which is relatively inert, i.e., does not deleteriously affect the process and which forms soluble salts with both the cation metal and the powder metal. Typical salts include copper nitrate, copper acetate, copper fluoroborate, potassium gold cyanide, nickel sulfate, nickel chloride, nickel sulfamate, potassium silver cyanide, silver chloride and the like. The presently preferred metal salt is copper sulfate. The concentration of the metal salt in the solution can range from 0.1 molar to saturation but is preferably about 0.5 - 2.0 molar. Below about 0.5 molar, deposition rates are inordinately slow and there is no improvement in rate at molarities about 2.0. Most preferably, the metal salt is present at a concentration of about 1 molar.

When copper sulfate is used as the augmentative metal, a copper layer is formed with a new unoxidized copper which can be readily soldered. If further enhancement is desired or if soldering of the circuits is to be delayed for a substantial period of time, the conductor pattern formed can be dipped in a tin plating solution so that the tin will replace some of the copper. Tin and copper are very close in the activity series and the normal replacement reaction would cause copper to be plated out on the tin. However, by adding appropriate complexing ions, the tin will replace the copper. The tin plated copper thus formed is very readily soldered and can be left for periods of a month or more and good soldering can still be achieved. Suitable tin plating solutions are commercially available for plating on copper such as, for example, Coppertech Electroless tin Plating Solution ST-210 or ST-240. The augmentation reaction can be carried out at any suitable temperature although elevated temperatures are generally preferred in order to increase reaction rate. Thus, any temperature from ambient up to about 100°C. can be employed although the temperature is preferably about 45° - 60°C. Generally the augmentation reaction is completed in about 2 minutes to 20 minutes or more, preferably about 5 minutes.

The first step of the process of the present invention is to coat a substrate and the conductive pattern adhered thereto with a photocurable dielectric polymeric material. The photocured thickness of the coating should be sufficient to substantially eliminate current flow between overlapping conductors or to prevent dielectric breakdown and the like. Thus, considering the electrical properties of the particular dielectric polymeric material chosen, the thickness of the uncured coating should be judged accordingly. Generally, at 100% solids, the uncured dielectric polymeric material is applied to a thickness of at least about 1 mil and preferably to a thickness of at least about 2 mil.

The dielectric polymeric material may be applied over the entire surface of both the substrate and conductive pattern. In this case, however, depending on the photo-pattern, excessive dielectric polymeric material is wasted upon removing the uncured dielectric polymeric material. Thus, it may be desirable to roughly apply the dielectric polymeric material to only those areas where the cured pattern of the dielectric layer is to be adhered. This may be done with a simple stencil in the case of a liquid photocurable dielectric polymeric material or by forming a dry film photocurable dielectric polymeric material to shape. It should be kept in mind, that the dielectric layer may be applied in substantially the pattern of the conductive pattern to which it is applied or it may be applied substantially in the pattern of a further conductive pattern which is to be applied. In the first instance, undesirable contacts are avoided between the first conductive pattern and all conductive patterns applied thereafter, and in the second instance undesirable contacts are avoided between the second conductive pattern and all conductive patterns applied therebefore.

Any dielectric polymeric material which has previously been employed and which can be rendered photo-curable is suitable for use in the present invention. For example, any of the curable polymers used as a bonder for the powder metal described above can be employed if they can be rendered photocurable and if they are sufficiently non-conductive in their cured state or can be rendered non-conductive with suitable fillers.

Ultraviolet light initiators will generally be necessary to render the polymeric material of choice photocurable. Aromatic onium salts of Group V1a elements may be used to render vinyl monomers, vinyl prepolymers, cyclic ethers, cyclic esters, cyclic sulfides and organosilicon cyclics photocurable. These aromatic onium salt photoinitiators are described in U.S. Pat. No. 4,058,400, hereby incorporated by reference. Onium salts of Group V1a elements may be used as photoinitiators for alkoxylated melamine resins, ureaformaldehyde resins, or phenolformaldehyde resins. These onium salt photoinitiators are described in U.S. Pat. No. 4,102,687, hereby incorporated by reference. Aromatic onium salts of Group V1a elements may be employed to render epoxy resins photocurable. These salts, include for example, triphenyl sulfonium tetrafluoroborate, triphenyl sulfonium hexafluoroantimonate, etc. and may be used to cure epoxy resins such as resins which result from the reaction of bisphenol-A and epichlorohydrin, the reaction of low molecular weight phenol-formaldehyde resins (Novolak resins) with epichlorohydrin, etc. These salts and epoxy resins which are cured thereby are disclosed in U.S. Pat. No. 4,138,255, hereby incorporated by reference. Other suitable photoinitiators and resins are well known to persons skilled in the art, for example, the peroxide cure of vinyl polymers. The present invention should not be limited to a particular photoinitiator or a particular dielectric polymeric material.

The photocurable dielectric polymeric material may be applied to the substrate as both a liquid or dry film. Where a liquid photocurable dielectric polymeric material is employed, generally, it is desirable to use an off-contact exposure template. Where a dry film, photocurable, dielectric polymeric material is employed, the exposure template may come into contact with its surface. The dry film may be formed in situ on the surface of the base. A solvent is used to carrry the dry film prepolymer solids onto the base and the solvent is subsequently evaporated with mild heating to leave a tack free dry film. Suitable solvents in the case of epoxy prepolymers include phenyl glycidyl ether, 4-vinylcyclohexene dioxide, limonene dioxide, glycidyl acrylate, 2-ethyl hexyl glycidyl ether. Solvents for other prepolymers may be easily imagined by persons skilled in the art.

Subsequent to coating the substrate with the photocurable dielectric polymeric material, the material is exposed to photocuring light in the pattern of the desired cure. In the case of a dry film photocurable dielectric polymeric material, this may be as simple as applying a template to the surface and exposing the unprotected surface to light. In the case of liquid photocurable dielectric materials, more sophisticated exposure schemes are usually required. Ultimate resolution is obtained by exposing with a point type light source or collinated light beam. The optimum exposure time will vary with the type and thickness of the photocurable polymeric material and the distance from the light source.

Subsequent to said exposure step, the photocurable polymeric material is developed to form the dielectric layer. Developing in the instant invention is generally as simple as washing the coated substrate with a suitable solvent to remove the uncured material. The particular solvents may vary depending on the polymeric material, however, it is essential that the solvent be chosen so that the dielectric layer or the cured polymeric material will not dissolve therein while the uncured polymeric material is easily washed away. Persons skilled in the art of polymeric materials are generally well able to determine proper solvents that will accomplish this end.

The purpose of applying the dielectric layer is to enable the placement of an additional conductive pattern to the same substrate. Thus, following application of the dielectric layer, a multi-layer conductor assembly may be formed by the further application of an augmentative replacement conductor to said dielectric layer as described above.

In order to further illustrate the present invention, various examples are set forth below. It will be appreciated that these examples are set forth in order to further illustrate the invention, but are not intended to limit it.

Further it should be appreciated that all parts and percentages are by weight and all temperatures in degrees Celsius throughout this specification and claims unless otherwise indicated.

EXAMPLE

Example 1

A dielectric layer was prepared in the following manner. A liquid was prepared by mixing 37 grams of a solid higher molecular weight homolog of the diglycidyl ether of bisphenol A (Epi-Rez 53 OC, Celanese Chemical), 25 grams of novolac epoxy (Den 438, Dow Chemical), 34 grams of 2 ethyl hexyl glycidyl ether (MK 116, Wilmington Chemical), 1.5 grams of cationic photo-initiator (UVE 1014, GE), 0.26 grams of a flow control agent (Modaflow, Monsanto), 0.16 grams of a surfactant (FC 430, 3M) and 0.1 grams of a blue pigment dispersion (Penn Color). This mix was screen printed through an imageless screen onto a substrate and dried at 130°C for fifteen minutes to form a dry to the touch film over the substrate. This was then exposed through a mask placed upon the film to ultra-violet radiation of the proper wavelength and intensity to activate the photo-initiator. After a ten minute at 130°C post bake, it was sprayed with methyl ethyl ketone and the sections protected from the radiation by the mask were washed away, while the sections exposed to the radiation through the mask stayed as a permanent insulating layer.

**Claims**

1. A method to apply a dielectric layer to a conductive pattern on a substrate, said method comprising the steps of
(a) coating said substrate and said conductive pattern with a photo-curable polymeric material,
(b) exposing said photo-curable polymeric material to photo-curing light in the pattern of desired cure, and
(c) developing said photocurable polymeric material to produce a dielectric layer.

2. The method of claim 1 wherein said dielectric layer has a thickness of at least about 1 mil.

3. The method of claim 1 wherein said photocurable polymeric material is coated on to said substrate and said conductive pattern in substantially the pattern of said conductive pattern.

4. The method of claim 1 wherein said photocurable polymeric material is coated on to said substrate and said conductive pattern in substantially the pattern of a conductive pattern to be established on said photo-curable polymeric material.

5. The method of claim 1 wherein said photocurable polymeric material is liquid at room temperature.

6. The method of claim 1 wherein said photocurable polymeric material is a dry film at room temperature.

7. The method of claim 1 wherein said photocuring light is ultraviolet light.

8. The method of claim 1 wherein said photocurable polymeric material is a photo-curable epoxy material.

9. A method to produce a multi-layer conductor assembly said method comprising the steps of:
(a) establishing a first conductive pattern on a substrate,

(b) coating said substrate and said pattern with a photo-curable polymeric material,

(c) exposing said photo-curable polymeric material to photo-curing light in the pattern of desired cure,

(d) developing said photo-curable polymeric material to produce a dielectric layer, and

(e) establishing a second conductive pattern on said dielectric layer.

10. The method of claim 9 wherein said dielectric layer has a thickness of at least about 1 mil.

11. The method of claim 9 wherein said photo-curable polymeric material is coated onto said substrate and said first conductive pattern in substantially the pattern of said first conductive pattern.

12. The method of claim 9 wherein said photo-curable polymeric material is coated onto said substrated and said first conductive pattern in substantially the pattern of said second conductive pattern.

13. The method of claim 9 wherein said photo-curable polymeric material is liquid at room temperature.

14. The method of claim 9 wherein said photo-curable polymeric material is a dry film at room temperature.

15. The method of claim 9 wherein said photo-curing light is ultraviolet light.

16. The method of claim 9 wherein said photo-curable polymeric material is a photo-curable ep-·oxy material.